# EUROPEAN PATENT SPECIFICATION

(11) **EP 2 469 604 B1**
(45) Date of publication and mention of the grant of the patent: **09.10.2019**
(21) Application number: 10809996.1
(22) Date of filing: 19.08.2010
(51) Int. Cl.: H01L 31/04, H01L 31/0224, H01L 31/05

(54) **SOLAR BATTERY MODULE**
SOLARBATTERIEMODUL
MODULE DE PILE SOLAIRE

(30) Priority: 19.08.2009 JP 2009189730
(43) Date of publication of application: 27.06.2012
(73) Proprietor: Panasonic Intellectual Property Management Co., Ltd., Osaka-shi, Osaka 540-6207 (JP)
(72) Inventor: TAIRA, Shigeharu, Moriguchi-shi Osaka 570-8677 (JP); KANNOU, Hiroyuki, Moriguchi-shi Osaka 570-8677 (JP)
(74) Representative: Mewburn Ellis LLP
(86) International application number: PCT/JP2010/063969
(87) International publication number: WO 2011/021655

(56) References cited:
- EP-A1- 2 418 686
- JP-A- 2000 261 012
- JP-A- 2001 274 426
- JP-A- 2004 200 515
- JP-A- 2006 237 363
- JP-A- 2008 147 567
- JP-A- 2008 235 354
- JP-A- 2009 043 801
- US-A1- 2008 121 265
- US-A1- 2009 038 675

## Description

### Technical Field

The invention relates to a solar cell, a solar cell module, and a solar cell system.

### Background Art

A solar cell system including solar cells is expected to be a new clean energy conversion system because of its capability of directly converting solar light into electricity, and has been increasingly utilized in a power supply for ordinary households and a power generation plant, in recent years.

In such a situation, in order to get solar cell systems into widespread use, research and development for cost reduction and enhanced performance of solar cells, for example, are highly practiced.

A conventional solar cell system includes, for example, one or a plurality of solar cell modules, and this solar cell module has a plurality of solar cells electrically connected to each other.

In the conventional solar cell module, generally, a space between a front electrode of one solar cell of adjacent solar cells and a rear electrode of the other solar cell thereof is connected by a connection member having conductive properties such as a copper foil with solder interposed therebetween. In the solar cell, for example, the abovementioned front electrode includes a plurality of finger electrodes having a narrow width which are formed within a region of an approximate overall area of the front surface of the solar cell, and a bus bar electrode having a wide width which is connected to this finger electrode. Furthermore, the abovementioned rear electrode includes a plurality of finger electrodes having a narrow width which are formed within a region of an approximate overall area of the rear surface of the solar cell, and a bus bar electrode having a wide width which is connected to this finger electrode.

Furthermore, a technique in which connection between the abovementioned conductive connection member and a front electrode or a rear electrode is achieved by a resin adhesive containing a resin is proposed recently. (For example, see Patent Literature 1).

When connection between the conductive connection member and the abovementioned front electrode or rear electrode in the use of a resin adhesive, the connection between the connection member and the electrode can be achieved, without solder being fused as in the case of the conventional technique. Accordingly, a bus bar electrode can be formed to have a narrower width compared with the conventional bus bar electrode, thereby making it possible to reduce the amount of electrode materials and a cost.

### Citation List

### Patent Literature

Patent Literature 1: Japanese Patent Application Publication No. 2008-147567 A, and other prior art documents such as EP 2418 686 A1, JP 2008 235354 A and US 2008/121265 A1 describe solar cell modules known in the prior art.

### SUMMARY OF THE INVENTION

### Technical Problem

However, if a bus bar electrode is formed to have a narrow width, in a step in which a connection member is pressure-pressed on and connected to a front electrode or a rear electrode, a pressing force applied on a solar cell via a bus bar electrode having a narrow width becomes larger compared with that of a bus bar electrode having a wide width. Furthermore, due to the cross section shape of the bus bar electrode having a narrow width or the pressing force mechanism, the pressing pressure on the bus bar electrode of the front electrode or the rear electrode is not applied to the front surface of the solar cell vertically but easily applies thereto non-uniformly. Accordingly, in a step in which the connection member is connected to the electrode, there is a fear that a fracture of the solar cell, a crack, or the like may be generated, and a manufacture yield may be reduced. In particular, the thinner the thickness of the substrate of the solar cell is, the more apparent this generation of a fracture or a crack in the solar cell becomes.

The invention is made in view of the abovementioned problem, and provides a solar cell, a solar cell module, and a solar cell system good in a manufacture yield.

### Solution to Problem

A solar cell according to the invention is defined in independent claims 1 and 4.

Note that, in the description, the region width of the connection electrode on the first principal-surface side electrode means a width or a width of the outline, of the connection electrode.

### BRIEF DESCRIPTION OF DRAWINGS

Fig. 1 is a top view of a solar cell module according to a first embodiment of the invention.
Fig. 2 is a perspective view of the solar cell module according to the first embodiment of the invention.
Fig. 3 is a partial cross-sectional view taken along the line A-A' in Fig. 1.
Fig. 4(a) is a top view and Fig. 4(b) is a rear view, of a solar cell according to the first embodiment.
Fig. 5(a) is a top view of the solar cell for explaining connection between the solar cell and a connection member in the solar cell module according to the first embodiment of the invention, and
Fig. 5(b) is a partial cross-sectional view taken along the line A-A' in Fig. 5(a).
Fig. 6(a) is a top view and Fig. 6(b) is a bottom view, of a solar cell according to a second embodiment of the invention.
Fig. 7(a) is a top view and Fig. 7(b) is a bottom view, of a solar cell according to a third embodiment of the invention.
Fig. 8(a) is a top view and Fig. 8(b) is a bottom view, of a solar cell according to a fourth embodiment of the invention.
Fig. 9(a) is a top view and Fig. 9(b) is a bottom view, of a solar cell according to a fifth embodiment of the invention.
Fig. 10(a) is a top view and Fig. 10(b) is a bottom view, of a solar cell according to a sixth embodiment of the invention.
Fig. 11 (a) is a top view and Fig. 11 (b) is a bottom view, of a solar cell according to a seventh embodiment of the invention.
Fig. 12 is a partial cross-sectional view of a solar cell module according to an eighth embodiment of the invention.
Fig. 13 is a partial cross-sectional view of a solar cell module according to a ninth embodiment of the invention.

### DESCRIPTION OF EMBODIMENTS

Next, embodiments of the invention are described using the drawings. In the description of the following drawings, the same or similar portions are donated with the same or similar reference numerals. However, it is noted that the drawings are schematic, and the ratio or the like of the respective dimensions is different from an actual one. Accordingly, specific dimensions and the like should be determined by considering the explanation below. Furthermore, naturally included are portions whose relations and ratios of the dimensions are different from each other between the drawings.

### (First Embodiment)

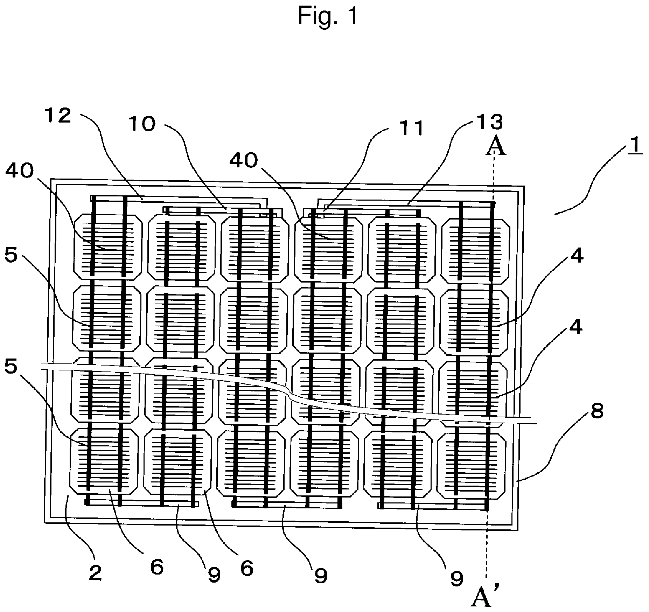

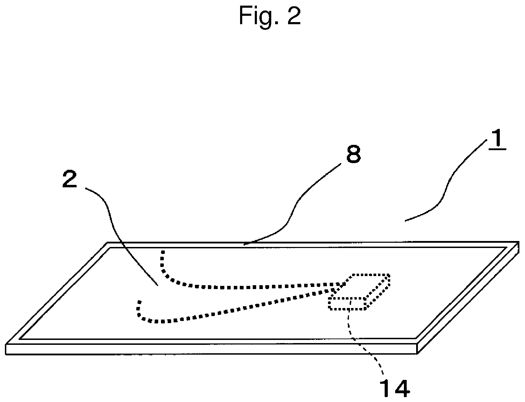

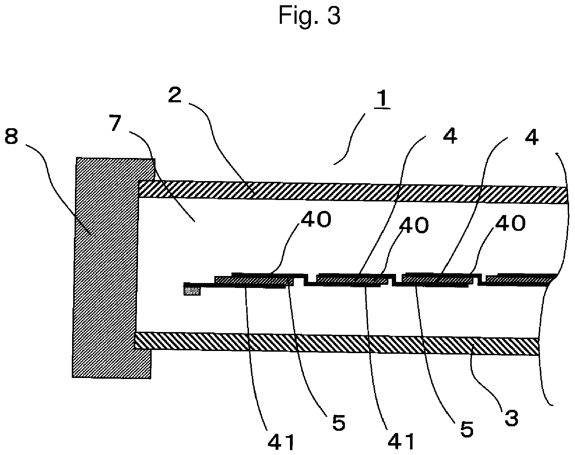

A first embodiment of the invention is described with reference to Fig. 1 to Fig. 5.

Solar cell module 1 comprises front cover 2, rear cover 3, a plurality of solar cells 4, and filler 7. The plurality of solar cells 4 are electrically connected by conductive connection members 5.

Front cover 2 is made of a translucent material, such as glass or translucent plastic, and allows the received solar light to pass through to the side of solar cells 4. Rear cover 3 is made of a material including a resin film, such as polyethylene terephthalate (PET), a resin film in which resin films are laminated such that a metal foil, such as an AI foil, is sandwiched therebetween, glass, or the like. Rear cover 3 may be translucent or non-translucent.

Filler 7 fills between front cover 2 and the plurality of solar cells 4, between rear cover 3 and the solar cells 4, and between adjacent solar cells 4, 4. Filler 7 is made, for example, of a resin including an ethylene vinyl acetate copolymer resin (EVA) or the like. Note that, in the invention, filler 7 which is filled in the spaces between front cover 2 and the plurality of solar cells 4, and filler 7 which is filled in the spaces between rear cover 3 and solar cells 4 are made of the same material, or made of materials different from each other.

Connection member 5 can be configured using a copper foil with a surface thereof coated with a solder layer, for example, however, the form of connection member 5 in the invention is not limited thereto.

Furthermore, solar cell module 1 is plate-shaped as a whole, and is attached with frame body 8 made of a metal such as aluminum on the outer circumference thereof if necessary. Furthermore, terminal box 14 for taking out an output from solar cell module 1 to the outside is attached to the surface of rear cover 3.

The plurality of solar cells 4 arranged in straight line shapes are electrically connected in series with each other by connection members 5, and constitute solar cell group 6 being line-shaped as a whole. Solar cell module 1 according to the embodiment has six solar cell groups 6. Solar cell groups 6 are disposed in parallel with each other. Accordingly, in solar cell module 1, the plurality of solar cells 4 are arranged in a matrix shape.

Solar cell groups 6, 6 disposed adjacent to each other are electrically connected in series by transition wiring 9, 10, and 11. First transition wiring 9 has a striped shape, second transition wiring 10 and third transition wiring 11 each have an L-character shape. Second transition wiring 10 and third transition wiring 11 each have a terminal portion for connecting to a bypass diode accommodated inside terminal box 14, on a tip of the L-character shaped wiring. First to third transition wiring 9, 10, and 11 can be configured, similarly to connection member 5, using a copper foil with a surface thereof coated with a solder layer, however, the form thereof is not limited thereto.

With the configuration as described above, all solar cells 4 are electrically connected in series in the embodiment. Furthermore, among the plurality of solar cells 4 electrically connected in series, to solar cells 4, 4 located on both ends electrically connected are L-character shaped extraction wiring 12 and 13 for taking out outputs therefrom to the outside. Extraction wiring 12 and 13 can be also configured, similarly to connection members 5, using a copper foil with a surface thereof coated with a solder layer, however, the form thereof is not limited thereto.

Note that, an insulating member including an insulating film such as polyethylene terephthalate (PET), an insulating resin such as an EVA, or the like is interposed in a portion where second transition wiring 10 and extraction wiring 12 intersect each other, in order to prevent an undesired short circuit between members 10 and 12. Similarly, an insulating member is interposed also in a portion where third transition wiring 11 and extraction wiring 13 intersect each other, in order to prevent an undesired short circuit between members 11 and 13 from occurring.

Furthermore, tip portions of second and third transition wiring 10 and 11 and extraction wiring 12 and 13 penetrate through rear cover 3 to lead in terminal box 14. In terminal box 14, bypass diodes are connected between extraction wiring 12 and second transition wiring 10, between second transition wiring 10 and third transition wiring 11, and between third transition wiring 11 and extraction wiring 13, respectively.

Solar cell 4 according to the embodiment is a crystalline solar cell having a crystalline semiconductor substrate such as a single crystalline silicon substrate or a polycrystalline silicon substrate. Examples of solar cell 4 include a hetero-junction type crystalline solar cell having an n-type single crystalline silicon substrate and a p-type amorphous semiconductor layer formed on the surface of this substrate, and a homo-junction type crystalline solar cell having a p-type polycrystalline silicon substrate and an n-type region formed on the surface of this substrate by heat diffusion. Furthermore, as a hetero-junction type crystalline solar cell, an HIT (Hetero-junction with Intrinsic Thin layer) junction type solar cell may be used, in which an i-type amorphous silicon layer having a thickness to the extent that does not substantially contribute power generation is interposed between the n-type single crystalline silicon substrate and the p-type amorphous silicon layer.

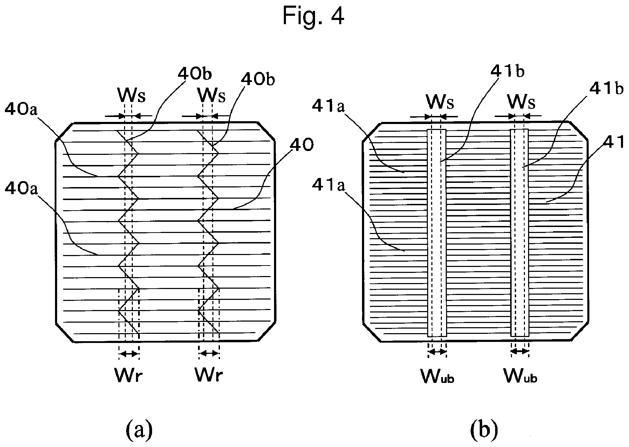

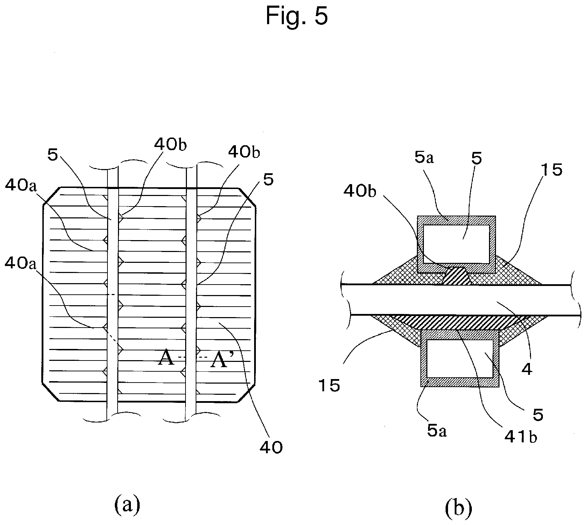

As shown in Fig. 4 and Fig. 5, solar cell 4 has a bifacial light receiving configuration capable of receiving light from both of the front and the rear. Note that, regions surrounded by the dashed line in Fig. 4 indicate regions where connection members 5 are disposed.

Front electrode 40 has a plurality of finger electrodes 40a disposed on an approximate overall area of the front surface of solar cell 4. Finger electrode 40a has an approximate straight-line shape, and the plurality of finger electrodes 40a are arranged in parallel with each other with a predetermined interval (for example, interval of 2 mm) . The width of finger electrode 40a is within a range of 50 µm to 120 µm, and preferably a range of 50 µm to 100 µm. Furthermore, the thickness of finger electrode 40a is within a range of 20 µm to 60 µm. Among photogenerated carriers (electrons or positive holes) which are generated in solar cells 4 due to reception of light, the plurality of finger electrodes 40a collect one type of the photogenerated carriers.

Furthermore, front electrode 40 has bus bar electrodes 40b disposed so as to intersect all finger electrodes 40b. Bus bar electrodes 40a collect electricity from the photogenerated carriers collected by the plurality of finger electrodes 40a. Bus bar electrode 40b has a zigzag line shape in which a plurality of straight lines are connected in a zigzag shape. The thickness of bus bar electrode 40b is within a range of 20 µm to 80 µm. Bus bar electrode 40b may be formed through a step the same as that of finger electrode 40a. In this case, the thickness of bus bar electrode 40b is equivalent to or slightly larger than the thickness of finger electrode 40a. Furthermore, the width of bus bar electrode 40b is formed to be equivalent to or slightly wider than the width of finger electrode 40a. The width of bus bar electrode 40b is within a range of 50 µm to 200 µm, and preferably within a range of 80 µm to 150 µm. Furthermore, a ratio Whf/Whb, which is a ratio of a line width Whf of finger electrode 40a to a line width Whb of bus bar electrode 40b, is within a range of 0.3 to 2.5, and preferably a difference between the line width of finger electrode 40a and the line width of bus bar electrode 40b is, for example, within an absolute value of 100 µm.

Furthermore, respective apexes (connection points) of zigzag-line shaped bus bar electrode 40b are located outside from a region where connection member 5 is disposed (a region sandwiched by the dashed lines) . Accordingly, when connection member 5 is connected, the respective apexes (connection points) of zigzag-line shaped bus bar electrode 40b and a vicinity thereof are exposed from the connection member 5. In other words, the width between the apexes of bus bar electrode 40b (the width of a region where bus bar electrode 40b is disposed: Wr in Fig. 4) is larger than the width of connection member 5 (Ws in Fig. 4) . The width of a region where bus bar electrode 40b is disposed is set such that, even when a disposed position of connection member 5 is shifted due to a mechanical error, connection member 5 is disposed on bus bar electrode 40b reliably. For example, when the width Ws of connection members 5 is 1.0 mm to 1.2 mm, the width Wr of the region where bus bar electrode 40b is disposed is set to 1.6 mm to 1.8 mm.

Note that, the number of finger electrodes 40a and the number of bus bar electrodes 40b can be set as appropriate in accordance with the size, physical properties, or the like, of the solar cell. For example, the number of bus bar electrodes 40b is two in Fig. 4, however, the number of bus bar electrodes 40b is not limited thereto and may be three or more.

Furthermore, in front electrode 40, finger electrode 40a preferably has a width as narrow as possible in order to reduce a loss due to light blocking and ensure the sufficient incidence of light on solar cell 4. For this purpose, when front electrode 40 is formed by screen printing, it is preferable to use the extend direction of finger electrode 40a as a printing direction. Furthermore, in order to prevent a print becoming faint of bus bar electrode 40b from being generated, the line width of bus bar electrode 40b is preferably set larger than the line width of finger electrode 40a. For example, the ratio Whf/Whb of the line width Whf of finger electrode 40a to the line width Whb of bus bar electrode 40b is set to not less than 0.3 and less than 1.

Furthermore, in front electrode 40 serving as a principal-surface side for receiving light, in order to achieve the low resistance and make reception of light by the solar cells be good, bus bar electrode 40b preferably has a narrow width thereof, and, in addition, the widths, that is the areas, of finger electrode 40a and bus bar electrode 40b are made small, while the thicknesses thereof are made large, compared with those of rear electrode 41 described later.

Rear electrode 41 has a plurality of finger electrodes 41a disposed on an approximate overall area of the rear surface of solar cell 4, and bus bar electrodes 41b. Finger electrodes 41a has an approximate straight-line shape, and the plurality of finger electrodes 41a are arranged in parallel with each other with a predetermined interval (for example, interval of 1 mm) . Because finger electrode 41a at the rear side is not required to consider a light receiving loss, the width thereof is formed to be equivalent to or wider than the width of finger electrode 40a at the front side. Finger electrode 41a is formed to have a width from 50 µm to 200 µm, for example. Furthermore, the thickness of finger electrode 41a is within a range of 5 µm to 60 µm. Furthermore, the number of finger electrodes 41a at the rear side is formed greater in number than the number of finger electrodes 40a at the front side because no loss due to light blocking is required to be considered. Such a configuration makes it possible to reduce a resistance loss of finger electrodes 41a. Note that, the plurality of finger electrodes 41a collect, among photogenerated carriers (electrons or positive holes) which are generated in solar cells 4, the other type of the photogenerated carriers.

Bus bar electrodes 41b are disposed so as to intersect all finger electrodes 41a, and collect electricity from the photogenerated carriers collected the plurality of finger electrodes 41a. Bus bar electrode 41b at the rear side is formed in a straight line shape having a width wider than that of finger electrode 41a. Furthermore, a width Wub of bus bar electrode 41b is larger than the width Ws of connection member 5. For example, when the width Ws of connection member 5 is from 1.0 mm to 1.2 mm, the width Wub of a region where bus bar electrode 41b is disposed is set to from 1.6 mm to 1.8 mm.

Note that, the number of bus bar electrodes 41b at the rear side is the same as the number of bus bar electrodes 40b at the front side. Bus bar electrodes 41b and bus bar electrodes 40b are disposed at positions opposed to each other from the surface and rear sides of solar cell 4. Furthermore, the width Wr of a region where bus bar electrode 40b at the front side is disposed is equivalent to the width Wub of a region where bus bar electrode 41b at the rear side is disposed.

Note that, because an effect of the light-receiving amount on element characteristics is smaller in rear electrode 41 compared with that in front electrode 40, the low resistance may be achieved by making the thickness of rear electrode 41 be thinner than that of front electrode 40, and the widths, that is the areas, of finger electrode 41a and bus bar electrode 41b be large.

Furthermore, solar cell 4 may have a transparent conductive film made of translucent conductive oxide such as indium oxide or zinc oxide, as a base of front electrode 40. Furthermore, solar cell 4 may have a transparent conductive film made of translucent conductive oxide such as indium oxide or zinc oxide, as a base of rear electrode 41.

Finger electrodes 40a and 41a and bus bar electrodes 40b and 41b described above include metals in order to reduce a resistance loss. For example, finger electrodes 40a and 41a and bus bar electrodes 40b and 41b can be made of a resin type or a ceramic type conductive paste, a metal, or an alloy. Furthermore, finger electrodes 40a and 41a and bus bar electrodes 40b and 41b can be formed using methods including a printing method such as screen printing or offset printing, a sputtering method, a vapor deposition method, or a plating method.

Wiring member 5 is connected to bus bar electrode 40b at the front side of one solar cell 4 and bus bar electrodes 41b at the rear side of the other solar cell 4, out of adjacent solar cells 4, 4, by resin adhesive 15. Specifically, wiring member 5 has an elongated shape, and one end portion side in the longitudinal direction is connected onto the surface of bus bar electrode 40b by resin adhesive 15 and the other end portion side is connected onto the surface of bus bar electrode 41b by resin adhesive 15. A resin component in resin adhesive 15 allows wiring member 5 to mechanically connect to the front surface or the rear surface of solar cells 4. Furthermore, direct contacts of the surfaces of wiring member 5 to the surface of bus bar electrode 40b and the surface of bus bar electrode 41b allow wiring member 5 to be electrically connected to bus bar electrodes 40b and 41b.

Resin adhesive 15 contains a resin. Furthermore, resin adhesive 15 has insulating properties or conductive properties. Examples of resin adhesive 15 having conductive properties include a resin adhesive with a resin having conductive particles. Examples of this resin adhesive include an anisotropic conductive adhesive. Note that, when conductive resin adhesive 15 containing conductive particles is used, wiring member 5 is also electrically connected to bus bar electrodes 40b and 41b via the conductive particles.

In the embodiment, connection member 5 has coating layer 5a on the surface of a main body thereof made of a metal such as a copper foil. Covering layer 5a above is made of solder or a conductive material such as tin or silver.

Fig. 5 shows an example in which coating layer 5a is made of a soft layer such as solder. Solder has a melting point from 230 to 260°C, for example. Resin adhesive 15 containing an epoxy-based resin and nickel particles which are conductive particles has a curing point at approximately 180°C. At the temperature at which resin adhesive 15 is caused to cure, bus bar electrode 40b is harder than coating layer 5a. In such a state, if connection member 5 is relatively pressure-pressed against solar cell 4, the tip of bus bar electrode 40b is embedded into coating layer 5a so that bus bar electrode 40b is brought into direct contact with the surface of connection member 5. In this manner, connection member 5 and bus bar electrode 40b are electrically connected to each other.

Resin adhesive 15 is present so as to spread over between, out of surfaces of connection member 5, the surface opposing to the front surface of solar cell 4, and the side surface of bus bar electrode 40b. In this manner, connection member 5 is mechanically connected to the front surface of solar cell 4. In addition, resin adhesive 15 is present so as to spread out from, out of surfaces of the connection members 5, the surface opposing to the front surface of solar cell 4, over the side surface bus bar electrode 40b, across the front surface of solar cell 4. Such a configuration makes it possible to improve the connection strength of connection members 5. Note that, in Fig. 5, resin adhesive 15 is present also on the side surfaces of connection member 5. Such a configuration makes it possible to further improve the connection strength of connection member 5.

Furthermore, at the rear surface of solar cell 4, the surface of coating layer 5a on the surface of the connection member 5 is brought into direct contact with the surface of bus bar electrode 41b. In this manner, connection member 5 and bus bar electrode 41b are electrically connected to each other. Furthermore, resin adhesive 15 is present so as to spread over between the side surface of connection member 5 and the surface of bus bar electrode 41b. In this manner, connection member 5 is mechanically connected to the rear surface of solar cell 4. Furthermore, resin adhesive 15 is present so as to spread out from the side surface of connection member 5, over the surface of bus bar electrode 41b, across the side surface of bus bar electrode 41b. Such a configuration makes it possible to improve the connection strength connection members 5. In addition, resin adhesive 15 is present so as to spread out from the side surface of connection member 5, over the surface of bus bar electrode 41b and the side surface of bus bar electrode 41b, across the rear surface of solar cell 4. Such a configuration makes it possible further to improve the connection strength of connection member 5.

Note that, an example in which a soft layer such as a solder layer is used as coating layer 5a is shown in Fig. 5, however, the invention is not limited thereto. A metal harder than solder, such as silver, can be used as coating layer 5a, or connection member 5 including no coating layer 5a can be also used. In this case, the tip of the bus bar electrode is brought into direct contact with the surface of connection member 5 without being embedded in coating layer 5a. Alternatively, the tip of the bus bar electrode of a deformed shape is brought into direct contact with the surface of connection member 5. Alternatively, the surface of connection member 5 is brought into direct contact with the bus bar electrode in a shape where a part thereof is embedded in the bus bar electrode. Such cases are also included in the invention.

In the embodiment, in a step in which connection member 5 is relatively pressure-pressed on and connected to solar cells 4, the pressing pressure on bus bar electrodes 40b and 41b on the front surface and the rear surface is not applied vertically but non-uniformly, and the pressing pressure applied on the solar cell results in a narrow range. Even in this case, because bus bar electrode 40b on the surface and bus bar electrode 41b on rear 1 function as reinforcing members, a fracture or a crack of solar cell 4 can be prevented from being generated, which leads to an improved manufacture yield.

In particular, the invention exhibits a prominent effect when a substrate included in solar cell 4 has a small thickness. For example, a crystalline silicon substrate having a 200 µm or less thickness can be applied naturally, and a crystalline silicon substrate having a 150 µm or less thickness may be applied. In addition, a crystalline silicon substrate having a 100 µm or less thickness leads to a good manufacture yield.

Furthermore, the region width Wr of bus bar electrode 40b and the region width Wub of bus bar electrode 41b are larger than the width Ws of connection member 5. This enables connection member 5 to be reliably disposed on the surfaces of bus bar electrodes 40b and 41b even if the mechanical accuracy when connection member 5 is disposed is low. Accordingly, the manufacture time can be reduced and the manufacture cost can be reduced.

Furthermore, front electrode 40 includes fine line-shaped finger electrode 40a having a narrow width and fine line-shaped bus bar electrode 40b having a narrow width. Furthermore, because rear electrode 41 includes fine line-shaped finger electrodes 41a having a narrow width, the material amount of the electrodes can be reduced. In addition, making the thickness of rear electrode 41 smaller can further reduce the material amount of the electrode.

Furthermore, bus bar electrode 40b has a zigzag shape, that is, a non-linear shape such as a saw-edged shape which is not a straight line shape. Accordingly, a configuration in which a contact portion between connection member 5 and bus bar electrode 40b is made larger is possible, compared with a case where bus bar electrode 40b is a fine line-shaped and straight line shaped. Accordingly, a good electrical connection between front electrode 40 and connection member 5 can be obtained. Furthermore, because an undesired external force to be applied is distributed, in addition that a contact portion is made larger, a fracture or a crack of solar cell 4 can be prevented from being generated, thereby improving reliability of the mechanical connection.

Furthermore, because the region width Wr of bus bar electrode 40b is larger than the width Ws of connection member 5, if resin adhesive 15 spreads out, an overhanging portion of bus bar electrode 40b easily allows the spread to be captured within the portion.

### (Manufacturing Method of Solar Cell Module)

A manufacturing method of a solar cell module according to the embodiment is described below.

Firstly, solar cell 4 including transparent electrode films on the front surface and the rear surface thereof is prepared.

Next, an epoxy-based thermosetting silver paste is printed on the transparent electrode film at the front side of solar cell 4 by screen printing, the printed transparent electrode film is heated at 200°C for an hour and is cured, to form front electrode 40. Then, similarly, an epoxy-based thermosetting silver paste is printed on the transparent electrode film at the rear side of solar cell 4 by screen printing, the printed transparent electrode film is heated at 200°C for an hour and is cured, to form rear electrode 41.

Next, a plurality of connection members 5 are prepared. Paste resin adhesive 15 is applied to a portion on one surface of each connection member 5 opposing to solar cell 4 and a portion on the other surface thereof opposing to solar cell 4 adjacent to solar cell 4 above such that connection member 5 have a thickness of approximately 30 µm, using a dispenser. Note that, resin adhesive 15 is not limited to be the paste resin adhesive, and a film-shaped resin adhesive may be used.

Next, connection member 5 is disposed on bus bar electrode 40b of front electrode 40 of one solar cell and on bus bar electrode 41b of rear electrode 41 of the other solar cell 4, 4 out of adjacent solar cells 4, 4 such that the faces thereof to which resin adhesive 15 is applied are opposed to each other, is heated at 200°C for an hour while being pressure-pressed at the pressure of approximately 2 MPa to cure resin adhesive 15. In this manner, connection member 5 is connected to both of the front surface and the rear surface of solar cell 4. This step is repeated to produce the plurality of solar cell groups 6.

Next, the plurality of solar cell groups 6 are electrically connected in series by first to third transition wiring 9, 10, and 11. Subsequently, extraction wiring 12 and 13 are connected to solar cells 4, 4 at both ends, respectively. In this manner, after a structure body in which all solar cells 4 are wired is produced, front cover 2, a filler sheet serving as filler 7, the structure body, a filler sheet serving as filler 7, and rear cover 3 are laminated in this order, and the laminated body thus obtained is heat press-bonded in a vacuum state at 150°C for 10 minutes. Then, the laminated body is heated at 150°C for one hour to cure the fillers perfectly.

Finally, terminal box 14, and frame body 8 if necessary, are attached to the laminated body to complete solar cell module 1.

### (Second Embodiment)

A second embodiment of the invention is described mainly about a difference from the first embodiment.

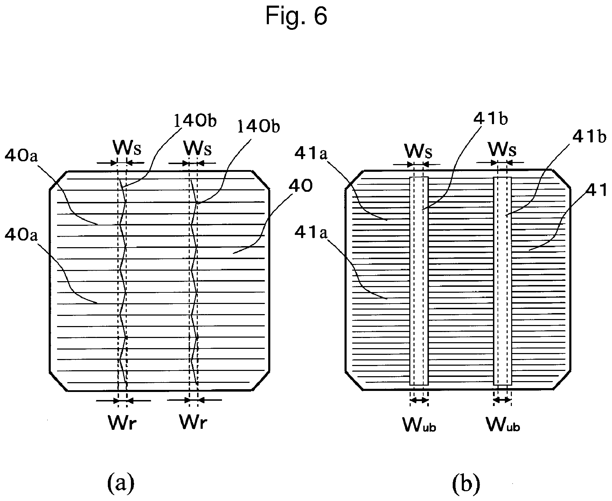

As shown in Fig. 6, the second embodiment is different from the first embodiment is in that a region width Wr of bus bar electrode 140b of front electrode 140 is equal to or narrower than the width Ws of connection member 5. Furthermore, the width of Wub of bus bar electrodes 41b of rear electrode 41 is configured so as to be equal to or larger than the width Ws of connection member 5, preferably larger than Ws, and equal to or larger than the region width Wr of bus bar electrode 140b of front electrode 140, preferably larger than Wr.

For example, the region width Wr of bus bar electrode 140b is set within a range of 0.6 mm to 1 mm, and the region width Wub of bus bar electrode 41b is set within a range of 1 to 1.6 mm, to 1.6 mm for example. Other points are the same as the first embodiment.

In the embodiment, more accuracy in manufacturing is required compared with the first embodiment, however, a cell fracture can be suppressed and the electrode material can be reduced compared with the first embodiment.

### (Third Embodiment)

A third embodiment of the invention is described mainly about a difference from the first embodiment.

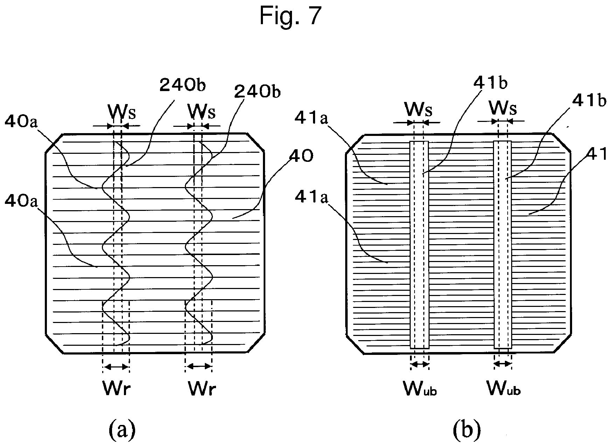

As shown in Fig. 7, solar cell 4 has a front electrode 40 on the front surface thereof including a plurality of straight line-shaped finger electrodes 40a having a narrow width which are disposed so as to cover an approximate overall area of the surface, and two pieces of waveform-shaped bus bar electrodes 240b having a narrow width which are connected to finger electrodes 40a. Furthermore, solar cell 4 has rear electrode 41 on the rear surface thereof including a plurality of straight line-shaped finger electrodes 41a having a narrow width which are disposed so as to cover an approximate overall area of the rear surface, and two pieces of strip-shaped bus bar electrodes 41b having a wide width which are connected to finger electrodes 41a.

The embodiment is different from the first embodiment is in that bus bar electrode 240a of front electrode 40 is waveform shaped, and other points are the same as the first embodiment.

The embodiment also can obtain an advantageous effect similarly to that of the first embodiment.

### (Fourth Embodiment)

A fourth embodiment of the invention is described mainly about a difference from the first embodiment.

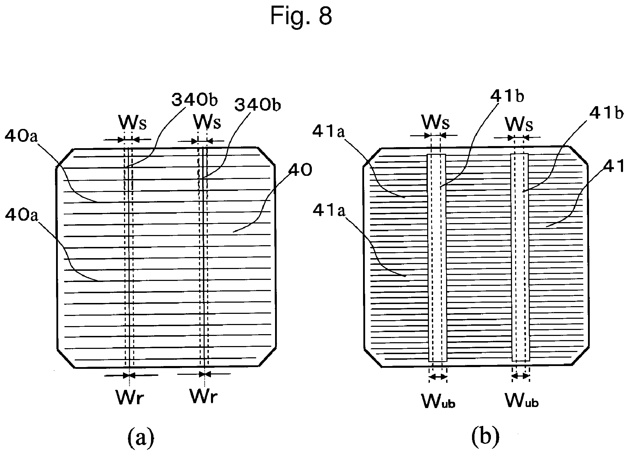

As shown in Fig. 8, solar cell 4 has a front electrode 40 on the front surface thereof including a plurality of straight line-shaped finger electrodes 40a having a narrow width which are disposed so as to cover an approximate overall area of the front surface, and two pieces of straight line-shaped bus bar electrodes 340b having a narrow width which are connected to finger electrodes 40a. Furthermore, solar cell 4 has rear electrode 41 on the rear surface thereof including a plurality of straight line-shaped finger electrodes 41a having a narrow width which are disposed so as to cover an approximate overall area of the rear surface, and two pieces of strip-shaped bus bar electrodes 41b having a wide width which are connected to finger electrodes 41a.

The embodiment is different from the first embodiment is in that the bus bar electrode 340b of front electrode 40 is straight line-shaped, and a region width Wr of bus bar electrode 340b is equal to the width Whb.

In the embodiment, bus bar electrode 340b of front electrode 40 is fine line-shaped similarly to finger electrode 40a, and a width Whb thereof is configured to be smaller than the width Ws of conductive connection member 5.

Furthermore, rear electrode 41 is configured such that the width Wub of bus bar electrode 41b is larger than the region width Wr of bus bar electrode 340b and equal to or larger than the width Ws of conductive connection member 5, and preferably larger than the width Ws of conductive connection member 5.

With the embodiment, electrode materials can be reduced and a cell fracture can be suppressed compared with the first embodiment.

### (Fifth Embodiment)

A fifth embodiment of the invention is described mainly about a difference from the first embodiment.

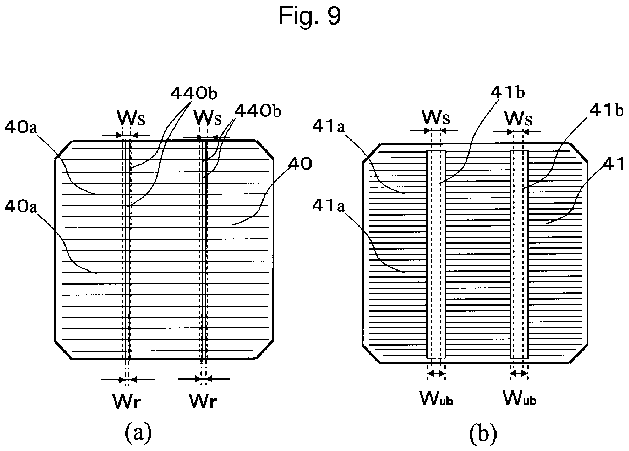

As shown in Fig. 9, solar cell 4 has front electrode 40 on the front surface thereof including a plurality of straight line-shaped finger electrodes 40a, 40a, ... having a narrow width which are disposed so as to cover an approximate overall area of the front surface, and two straight line-shaped bus bar electrodes 440b, 440b, consisting of sets of two and having a narrow width, which are connected to finger electrodes 40a, 40a. Furthermore, solar cell 4 has rear electrode 41 on the rear surface thereof including a plurality of straight line-shaped finger electrodes 41a, 41a, ... having a narrow width which are disposed so as to cover an approximate overall area of the rear surface, and two pieces of strip-shaped bus bar electrodes 41b having a wide width which are connected to finger electrodes 41a, 41a.

The embodiment is different from the first embodiment is in that bus bar electrode 440b of front electrode 40 is straight line-shaped, consists of sets of two, and has a narrow width, and other points are the same as the first embodiment.

Also with the embodiment, the amount of electrode materials can be suppressed and a cell fracture can be suppressed.

### (Sixth Embodiment)

A sixth embodiment of the invention is described mainly about a difference from the first embodiment.

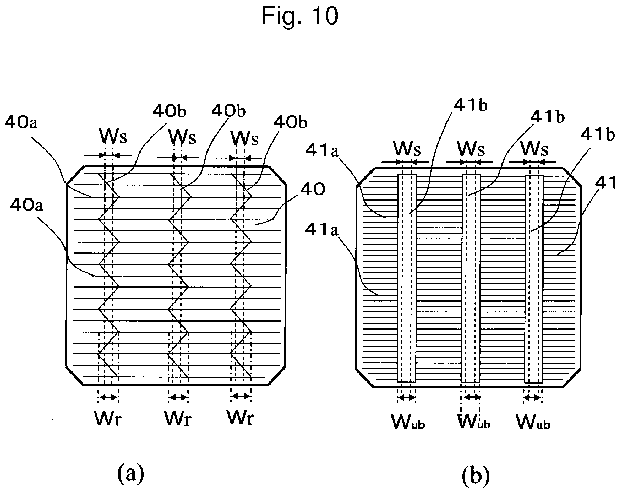

The embodiment is different from the first embodiment in that, as shown in Fig. 10, front electrode 40 has three bus bar electrodes 40b, 40b, 40b, and rear electrode 41 has three bus bar electrodes 41b, 41b, 41b.

With the embodiment, an advantageous effect similarly to that of the first embodiment can be obtained. In addition, because the embodiment includes three bus bar electrodes on the front surface and the rear surface, respectively, an advantageous effect of increased power-collecting efficiency can be obtained.

### (Seventh Embodiment)

A seventh embodiment of the invention is described mainly about a difference from the first embodiment.

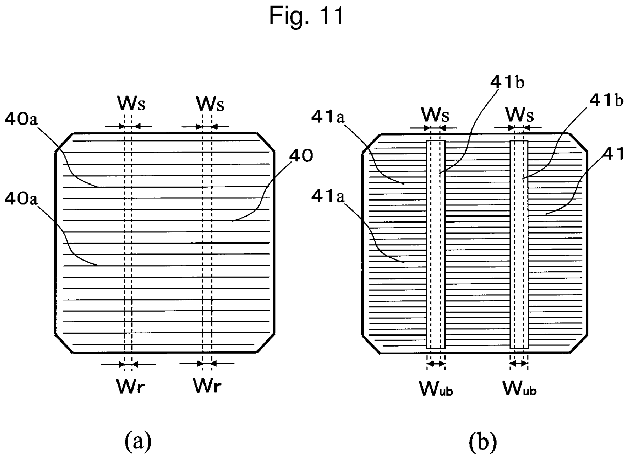

The embodiment is different from the first embodiment in that, as shown in Fig. 11, front electrode 40 has a busbarless structure in which no bus bar electrode is included, and other points are the same.

With such a busbarless structure, in a state where an adhesive made of a resin is soft, in a step in which front electrode 40 or/and bus bar electrode 41b of rear electrode 41 and conductive connection member 5 are pressure-pressed and connected to each other, the pressing pressure on front electrode 40 and bus bar electrodes 41b of rear electrode 41 is not applied vertically but non-uniformly, and the pressing pressure on the solar cell is concentrated in a narrow range. Even in this case, because bus bar electrodes 41b of rear electrode 41 having a width equal to or more than a value of the width Ws of conductive connection member 5, preferably a value more than the value of Ws, function as reinforcing members, a cell fracture can be reduced, which leads to an improved manufacture yield.

The embodiment also can obtain an advantageous effect similarly to that of the first embodiment.

### (Eighth Embodiment)

An eighth embodiment of the invention is described mainly about a difference from the first embodiment.

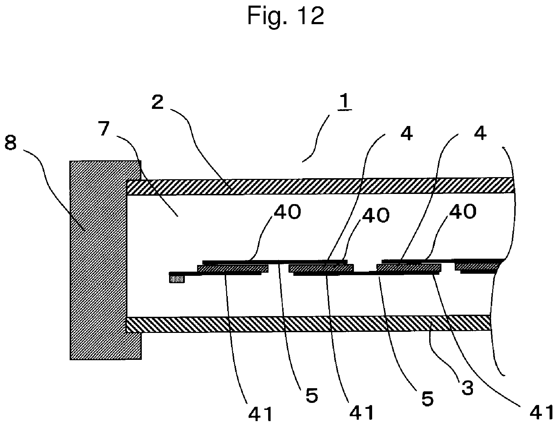

The embodiment is different from the first embodiment in that, as shown in Fig. 12, adjacent solar cells 4, 4 have an element configuration in which polarities thereof are reversed with each other. Connection members 5, 5, ... electrically connect in series between front electrodes 40 and 40 of adjacent solar cells 4, 4, and between rear electrodes 41 and 41 of solar cells 4, 4, respectively.

Also with the embodiment, the amount of electrode materials can be suppressed and a manufacture yield is good.

### (Ninth Embodiment)

A ninth embodiment of the invention is described mainly about a difference from the first embodiment.

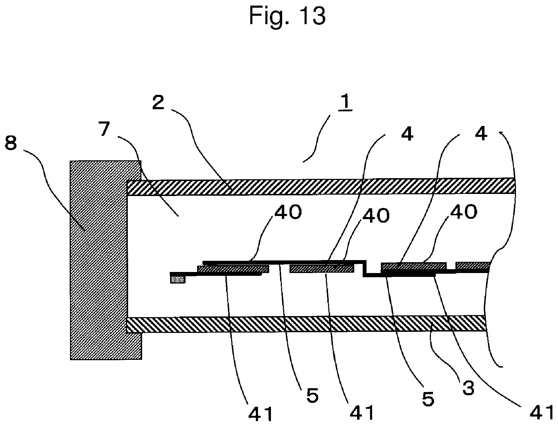

The embodiment is different from the first embodiment in that, as shown in Fig. 13, adjacent two solar cells 4, 4 are disposed electrically in parallel as a pair.

Also with the embodiment, the amount of electrode materials can be suppressed and a manufacture yield is good.

### (Tenth Embodiment)

Next, a solar cell system according to a tenth embodiment of the invention is described.

The solar cell system according to the embodiment is configured to include a plurality of solar cell modules 1 according to the first embodiment to the ninth embodiment, and a control system for controlling these solar cell modules. These solar cell modules are attached and fixed to roof faces, respectively, on a roof of a private house, for example, using fixing screws, and adjacent solar cell modules are engaged with each other, to install the solar cell modules in a thatched roof form (stepwise form) from the lower side (eaves side) toward the upper side (ridge side).

With the solar cell system according to the embodiment, the amount of electrode materials can be suppressed and a manufacture yield is good.

The abovementioned solar cell system is a solar cell system for a private house, for example, however, the invention is not limited thereto. Furthermore, an install method of solar cell modules can be changed as appropriate.

The solar cells according to the abovementioned respective embodiments are described by using a so-called HIT solar cell, however, can be used for various solar cells including a single crystalline solar cell, a polycrystalline solar cell, and the like, as appropriate, and can be applicable to a one-side light receiving type solar cell, in addition to a double-sided light receiving type solar cell.

As for the abovementioned polycrystalline solar cell or single crystalline solar cell, for example, a solar cell may be used in which an n+ layer is formed from the front surface to a portion having a predetermined depth of a silicon substrate including a P-type polycrystalline or a P-type single crystalline to form a pn junction, a p+ layer is formed from the rear surface to a portion having a predetermined depth of the silicon substrate, front electrode 40 is formed on the n+ layer, and rear electrode 41 is formed on the p+ layer.

In the abovementioned respective embodiments, the rear electrode is an electrode including finger electrodes and bus bar electrodes, however, can be applicable, for example, to an electrode in which a rear electrode has another structure, for example, a rear electrode including an electrode in which an entire surface thereof is covered with a metal film, and a bus bar electrode which is formed on this electrode.

In addition, the solar cell module of the invention is not limited to the solar cell modules of the abovementioned respective embodiments, and for example, may be a configuration including no frame body.

Furthermore, the solar cell module of the invention may be a double-sided type solar cell module, and for example, both a surface-side cover and a rear-side cover are made of glass plates.

In addition, in the abovementioned respective embodiments, the front electrode and the rear electrode include two or three bus bar electrodes, respectively. However, the number thereof may be changed as appropriate.
1 solar cell module
4 solar cell
5 connection member
40 front electrode (principal-surface side electrode)
40a finger electrode
40b, 140b, 240b, 340b, 440b bus bar electrode (connection electrode)
41 rear electrode (principal-surface side electrode)
41a finger electrode (collector electrode)
41b, 141b, 241b, 341b, 441b bus bar electrode (connection electrode)

## Claims

1. A solar cell module (1) comprising:
a plurality of solar cells (4), each of which includes a first principal-surface side electrode (40) and a second principal-surface side electrode (41); and
a connection member (5) for solar cell connection which is connected onto the first principal-surface side electrode (40) of one of the plurality of solar cells (4) and onto the second principal-surface side electrode (41) of another one of the plurality of solar cells (4), wherein:
the first principal-surface side electrode (40) comprises a plurality of fine line-shaped electrodes (40a) and a non-linear-shaped connection electrode (40b, 240b) electrically connected to the plurality of fine line-shaped electrodes (40a), wherein a width of the connection electrode (40b, 240b) of the first principal-surface side electrode (40) is smaller than a width of the connection member (5), and
the second principal-surface side electrode (41) comprises a collector electrode (41a) and a linear-shaped connection electrode (41b) electrically connected to the collector electrode (41a),
wherein a width (Wub) of the connection electrode (41b) of the second principal-surface side electrode (41) is not less than a region width (Wr) of the connection electrode (40b, 240b) of the first principal-surface side electrode (40); and
the width (Wub) of the connection electrode (41b) of the second principal-surface side electrode (41) is not less than the width (Ws) of the connection member (5).

2. The solar cell module (1) according to claim 1, **characterized in that** the region width (Wr) of the connection electrode (40b, 240b) of the first principal-surface side electrode (40) is not less than the width of the connection member (5).

3. The solar cell module (1) according to claim 1, **characterized in that** the connection member (5) is connected to the first principal-surface side electrode (40) of said one solar cell (4) and the second principal-surface side electrode (41) of said another solar cell (4) by an adhesive containing a resin.

4. A solar cell module (1) comprising:
a plurality of solar cells (4), each of which includes a first principal-surface side electrode (40) and a second principal-surface side electrode (41); and
a connection member (5) for solar cell connection which is connected onto the first principal-surface side electrode (40) of one of the plurality of solar cells (4) and onto the second principal-surface side electrode (41) of another one of the plurality of solar cells (4), wherein
the first principal-surface side electrode (40) comprises a plurality of fine line-shaped electrodes (40a) and a linear-shaped connection electrode (340b, 440b) electrically connected to the plurality of fine line-shaped electrodes (40a), wherein a width of the connection electrode (340b, 440b) of the first principal-surface side electrode (40) is smaller than a width of the connection member (5), and
the second principal-surface side electrode (41) comprises a collector electrode (41a) and a linear-shaped connection electrode (41b) electrically connected to the collector electrode (41a),
wherein a width of the connection electrode (41b) of the second principal-surface side electrode (41) is not less than the width of the connection electrode (340b, 440b) of the first principal-surface side electrode (40), and
the width (Wub) of the connection electrode (41b) of the second principal-surface side electrode (41) is not less than the width (Ws) of the connection member (5).

5. The solar cell module (1) according to claim 4, wherein the connection electrode (340b, 440b) of the first principal-surface side electrode (40) comprises a plurality of connection electrodes (340b, 440b) .

6. The solar cell module (1) according to claim 4, wherein the connection member (5) is connected to the first principal-surface side electrode (40) of said one solar cell (4) and the second principal-surface side electrode (41) of said another solar cell (4) by an adhesive containing a resin.

## Patentansprüche

1. Solarzellenmodul (1), umfassend:
eine Vielzahl von Solarzellen (4), die jeweils eine erste hauptflächenseitige Elektrode (40) und eine zweite hauptflächenseitige Elektrode (41) umfassen; und
ein Verbindungselement (5) zur Solarzellenverbindung, das mit der ersten hauptflächenseitigen Elektrode (40) von einer aus der Vielzahl von Solarzellen (4) und mit der zweiten hauptflächenseitigen Elektrode (41) einer weiteren aus der Vielzahl von Solarzellen (4) verbunden ist,
wobei die erste hauptflächenseitige Elektrode (40) eine Vielzahl von feinlinienförmig ausgebildeten Elektroden (40a) und eine nicht-linearförmig ausgebildete Verbindungselektrode (40b, 240b), die mit der Vielzahl von feinlinienförmig ausgebildeten Elektroden (40a) elektrisch verbunden ist, umfasst, wobei eine Breite der Verbindungselektrode (40b, 240b) der ersten hauptflächenseitigen Elektrode (40) kleiner als eine Breite des Verbindungselements (5) ist, und
wobei die zweite hauptflächenseitige Elektrode (41) eine Sammelelektrode (41a) und eine mit der Sammelelektrode (41a) elektrisch verbundene, linearförmig ausgebildete Verbindungselektrode (41b) umfasst,
wobei eine Breite (Wub) der Verbindungselektrode (41b) der zweiten hauptflächenseitigen Elektrode (41) nicht kleiner als eine Regionsbreite (Wr) der Verbindungselektrode (40b, 240b) der ersten hauptflächenseitigen Elektrode (40) ist; und
wobei die Breite (Wub) der Verbindungselektrode (41b) der zweiten hauptflächenseitigen Elektrode (41) nicht kleiner als die Breite (Ws) des Verbindungselements (5) ist.

2. Solarzellenmodul (1) gemäß Anspruch 1, **dadurch gekennzeichnet, dass** die Regionsbreite (Wr) der Verbindungselektrode (40b, 240b) der ersten hauptflächenseitigen Elektrode (40) nicht kleiner als die Breite des Verbindungselements (5) ist.

3. Solarzellenmodul (1) gemäß Anspruch 1, **dadurch gekennzeichnet, dass** das Verbindungselement (5) mit der ersten hauptflächenseitigen Elektrode (40) der einen Solarzelle (4) und der zweiten hauptflächenseitigen Elektrode (41) der weiteren Solarzelle (4) durch einen ein Harz enthaltenden Klebstoff verbunden ist.

4. Solarzellenmodul (1), umfassend:
eine Vielzahl von Solarzellen (4), die jeweils eine erste hauptflächenseitige Elektrode (40) und eine zweite hauptflächenseitige Elektrode (41) umfassen; und
ein Verbindungselement (5) zur Solarzellenverbindung, das mit der ersten hauptflächenseitigen Elektrode (40) von einer aus der Vielzahl von Solarzellen (4) und mit der zweiten hauptflächenseitigen Elektrode (41) einer weiteren aus der Vielzahl von Solarzellen (4) verbunden ist,
wobei die erste hauptflächenseitige Elektrode (40) eine Vielzahl von feinlinienförmig ausgebildeten Elektroden (40a) und eine linearförmig ausgebildete Verbindungselektrode (340b, 440b), die mit der Vielzahl von feinlinienförmig ausgebildeten Elektroden (40a) elektrisch verbunden ist, umfasst, wobei eine Breite der Verbindungselektrode (340b, 440b) der ersten hauptflächenseitigen Elektrode (40) kleiner als eine Breite des Verbindungselements (5) ist, und
wobei die zweite hauptflächenseitige Elektrode (41) eine Sammelelektrode (41a) und eine mit der Sammelelektrode (41a) elektrisch verbundene, linearförmig ausgebildete Verbindungselektrode (41b) umfasst,
wobei eine Breite der Verbindungselektrode (41b) der zweiten hauptflächenseitigen Elektrode (41) nicht kleiner als die Breite der Verbindungselektrode (340b, 440b) der ersten hauptflächenseitigen Elektrode (40) ist, und
wobei die Breite (Wub) der Verbindungselektrode (41b) der zweiten hauptflächenseitigen Elektrode (41) nicht kleiner als die Breite (Ws) des Verbindungselements (5) ist.

5. Solarzellenmodul (1) gemäß Anspruch 4, wobei die Verbindungselektrode (340b, 440b) der ersten hauptflächenseitigen Elektrode (40) eine Vielzahl von Verbindungselektroden (340b, 440b) umfasst.

6. Solarzellenmodul (1) gemäß Anspruch 4, wobei das Verbindungselement (5) mit der ersten hauptflächenseitigen Elektrode (40) der einen Solarzelle (4) und der zweiten hauptflächenseitigen Elektrode (41) der weiteren Solarzelle (4) durch einen ein Harz enthaltenden Klebstoff verbunden ist.

## Revendications

1. Module de cellules solaires (1) comprenant :
une pluralité de cellules solaires (4), chacune d'entre elles comprenant une première électrode côté surface principale (40) et une seconde électrode côté surface principale (41); et
un élément de connexion (5) pour une connexion de cellule solaire qui est connecté à la première électrode côté surface principale (40) d'une première de la pluralité de cellules solaires (4) et à la seconde électrode côté surface principale (41) d'une autre de la pluralité de cellules solaires (4), dans lequel :
la première électrode côté surface principale (40) comprend une pluralité d'électrodes en forme de ligne fines (40a) et une électrode de connexion de forme non linéaire (40b, 240b) connectée électriquement à la pluralité d'électrodes en forme de ligne fines (40a), dans lequel une largeur de l'électrode de connexion (40b, 240b) de la première électrode côté surface principale (40) est inférieure à la largeur de l'élément de connexion (5), et
la seconde électrode côté surface principale (41) comprend une électrode de collecteur (41a) et une électrode de connexion de forme linéaire (41b) connectée électriquement à l'électrode de collecteur (41a),
dans lequel une largeur (Wub) de l'électrode de connexion (41b) de la seconde électrode côté surface principale (41) n'est pas inférieure à une largeur de région (Wr) de l'électrode de connexion (40b, 240b) de la première électrode côté surface principale (40) ; et
la largeur (Wub) de l'électrode de connexion (41b) de la seconde électrode côté surface principale (41) n'est pas inférieure à la largeur (Ws) de l'élément de connexion (5).

2. Module de cellules solaires (1) selon la revendication 1, **caractérisé en ce que** la largeur de région (Wr) de l'électrode de connexion (40b, 240b) de la première électrode côté surface principale (40) n'est pas inférieure à la largeur de l'élément de connexion (5).

3. Module de cellules solaires (1) selon la revendication 1, **caractérisé en ce que** l'élément de connexion (5) est connecté à la première électrode côté surface principale (40) de ladite première cellule solaire (4) et à la seconde électrode côté surface principale (41) de ladite autre cellule solaire (4) par un adhésif contenant une résine.

4. Module de cellules solaires (1) comprenant :
une pluralité de cellules solaires (4), chacune d'entre elles comprenant une première électrode côté surface principale (40) et une seconde électrode côté surface principale (41); et
un élément de connexion (5) pour une connexion de cellule solaire qui est connecté à la première électrode côté surface principale (40) d'une première de la pluralité de cellules solaires (4) et à la seconde électrode côté surface principale (41) d'une autre de la pluralité de cellules solaires (4), dans lequel
la première électrode côté surface principale (40) comprend une pluralité d'électrodes en forme de ligne fines (40a) et une électrode de connexion de forme linéaire (340b, 440b) connectée électriquement à la pluralité d'électrodes en forme de ligne fines (40a), dans lequel une largeur de l'électrode de connexion (340b, 440b) de la première électrode côté surface principale (40) est inférieure à la largeur de l'élément de connexion (5), et
la seconde électrode côté surface principale (41) comprend une électrode de collecteur (41a) et une électrode de connexion de forme linéaire (41b) connectée électriquement à l'électrode de collecteur (41a),
dans lequel une largeur de l'électrode de connexion (41b) de la seconde électrode côté surface principale (41) n'est pas inférieure à une largeur de l'électrode de connexion (340b, 440b) de la première électrode côté surface principale (40) ; et
la largeur (Wub) de l'électrode de connexion (41b) de la seconde électrode côté surface principale (41) n'est pas inférieure à la largeur (Ws) de l'élément de connexion (5).

5. Module de cellules solaires (1) selon la revendication 4, dans lequel l'électrode de connexion (340b, 440b) de la première électrode côté surface principale (40) comprend une pluralité d'électrodes de connexion (340b, 440b) .

6. Module de cellules solaires (1) selon la revendication 4, dans lequel l'élément de connexion (5) est connecté à la première électrode côté surface principale (40) de ladite première cellule solaire (4) et à la seconde électrode côté surface principale (41) de ladite autre cellule solaire (4) par un adhésif contenant une résine.
